# EUROPEAN PATENT SPECIFICATION

(11) **EP 0 848 223 B1**
(45) Date of publication and mention of the grant of the patent: **04.12.2002**
(21) Application number: 96928741.6
(22) Date of filing: 30.08.1996
(51) Int. Cl.: F27B 1/09, H01L 21/22, C30B 31/12, C23C 16/46, C30B 25/10

(54) **VERTICAL HEAT TREATMENT DEVICE**
VERTIKALE WÄRMEBEHANDLUNGSVORRICHTUNG
DISPOSITIF DE TRAITEMENT THERMIQUE VERTICAL

(30) Priority: 04.06.1996 JP 16537596
(43) Date of publication of application: 17.06.1998
(73) Proprietor: Axcelis Technologies, Inc., Beverly, MA 01915 (US)
(72) Inventor: YAMADA, Yoshimitsu, Sanda Factory of Nippon, Shimouchigami, Sanda-shi, Hyogo 669-13 (JP); OGINO, Kozo, Sanda Factory of Nippon, Shimouchigami, Sanda-shi, Hyogo 669-13 (JP)
(74) Representative: Burke, Steven David
(86) International application number: JP9602484
(87) International publication number: WO97046842

(56) References cited:
- EP-A- 0 538 874
- WO-A-90/14158
- JP-A- 7 193 020
- JP-B- 6 093 439
- JP-B- 6 093 440
- US-A- 3 916 822
- US-A- 5 136 978
- US-A- 5 407 485

## Description

### Field of the Invention

The present invention relates to a vertical heat treatment equipment utilized for oxide film formation, impurity diffusion, or deposit film formation, for example, in the producing process of the wafers of the semiconductor.

### Background Art

The heat treatment equipment with a heating furnace has conventionally been utilized in the art for operations such as annealing, diffusion of impurities including phosphorus, arsenic and the like, oxide film formation, chemical vapor deposition and the like. As one type of the heat treatment equipment, there has been provided an equipment of a vertical furnace system wherein one or more wafers of the semiconductor are heated as supported in a horizontal position (see, for example, Japanese Unexamined Patent Publication No.2(1990)-14514).

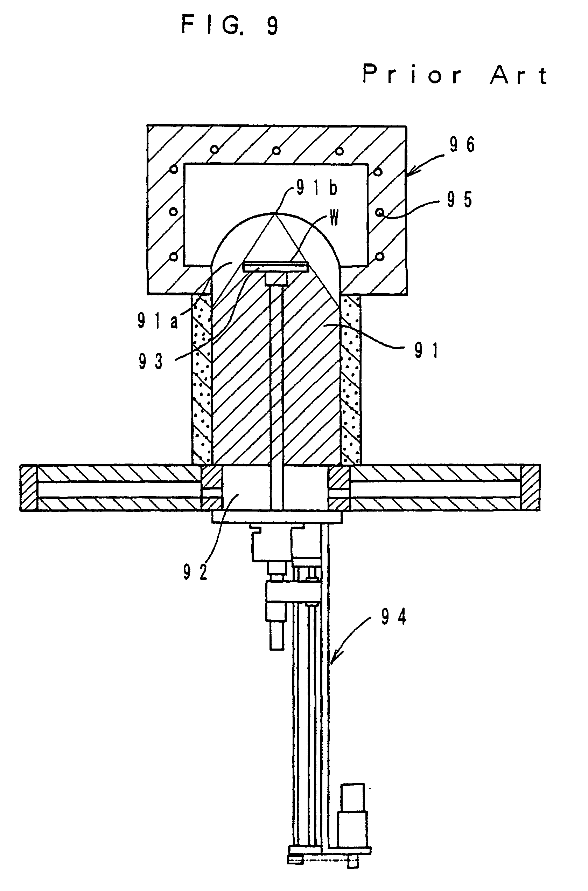

As shown in Fig. 9, this type of heat treatment equipment typically comprises a process chamber 91 adapted for heat treatment of a wafer W of the semiconductor and a carrier chamber 92 disposed under the process chamber 91 for feeding the wafer W thereto or for taking out the heat-treated wafer W therefrom. The wafer W of the semiconductor fed to the carrier chamber 92 is supported by a support 93 and transported by elevating means 94 up to a heat-treatment position 91a in the process chamber 91 so as to be subjected to the heat treatment by means of a heating furnace 96 equipped with a heater 95 of a resistance heating system.

The aforesaid vertical heat treatment equipment known to the art is arranged such that the heater 95 of the heating furnace 96 is concentrated near the top of the process chamber 91 whereby the process chamber 91 has a distribution of temperature, which is the highest at a top 91b of the process chamber and gradually decreases toward the lower portion thereof. This provides an efficient heating of an upper side of the wafer W of the semiconductor.

Unfortunately, the conventional vertical heat treatment equipment, particularly right after the start of the heat treatment, fails to assure a processing precision (so-called uniformity) such as of a uniform film thickness of a single wafer W of the semiconductor, as well as a processing precision (so-called repeatability) such as of a uniform film thickness of a plurality of wafers W.

The inventors have investigated the causes of the aforesaid problems to find the following fact. That is, the heating furnace 96 has the heater 95 concentrated near the top portion of the process chamber 91, and therefore, when the wafer W of the semiconductor is set to the heat-treatment position 91a in the process chamber 91, the wafer W and the support 93 block radiant heat from the heater 95 thereby producing a lower-temperature region extended under the heat-treatment position 91a, as shown by a diagonally shaded area in Fig. 9. The lower-temperature region is responsible for change in the thermal history of the wafer W of the semiconductor while the wafer W moves up and down.

The present invention has been accomplished based on such a finding and has an object to provide a vertical heat treatment equipment assuring the uniformity and repeatability of workpieces.

US-A-5 407 485 discloses a heat treatment apparatus having heaters arranged laterally with respect to a heat treatment position of a workpiece.

EP-A-0 538 874 also discloses a heat treatment apparatus having heaters arranged laterally with respect to heat treatment positions of a workpiece.

### DISCLOSURE OF THE INVENTION

The invention provides a vertical heat treatment apparatus as set out in claim 1.

In the vertical heat treatment apparatus of the aforementioned construction, the heater of the heating furnace is located laterally of the heat-treatment position in the process chamber and therefore, the workpiece and the support are prevented from blocking the radiant heat from the heater, thus producing no lower-temperature region extended under the heat-treatment position. This provides a fixed thermal history while the workpiece moves up and down and hence, a good uniformity and repeatability of workpieces is ensured. Furthermore, the workpiece is subject to an efficient heat treatment because the process chamber has a distribution in which a heating temperature is at the maximum at the heat-treatment position.

The lamp heater is utilized for heating the central portion of the workpiece thereby preventing the occurrence of a temperature difference between the central portion and a peripheral portion of the workpiece. Thus is provided a more uniform and more efficient heat treatment of the workpiece.

In a preferred mode of the invention, the vertical heat treatment equipment further comprises an input-power control section adapted to control power supplied to the lamp heater in accordance with a vertical position of the workpiece so as to maintain a uniform quantity of heat applied to the central and peripheral portions of the workpiece at any different vertical positions. According to this mode of the invention, the central and peripheral portions of the workpiece can be uniformly heated at any different vertical positions. Thus is provided a more uniform and more efficient heat treatment of the workpiece.

In another preferred mode of the invention, the vertical heat treatment equipment further comprises a gas supply opening disposed at an upper portion of the process chamber for supplying a treatment gas to the workpiece. According to this mode, the treatment gas is allowed to flow down directly onto the workpiece via the gas supply opening thereabove and hence, a turbulence of a treatment-gas flow around the workpiece can be prevented even if the workpiece is elevated quickly. Thus is provided a further uniform and efficient heat treatment of the workpieces.

### BRIEF DESCRIPTION OF THE DRAWINGS

Fig. 1 is a sectional view for illustrating a vertical heat treatment equipment;
Fig. 2 is a schematic diagram for illustrating a distribution of heating temperature in the process chamber;
Fig. 3 is a sectional view for illustrating an essential portion of the vertical heat treatment equipment of Fig. 1;
Fig. 4 is a graphical representation of the results of comparison tests;
Fig. 5 is a sectional view for illustrating an essential portion of the vertical heat treatment equipment according to an embodiment of the invention;
Fig. 6 is a sectional view for illustrating an essential portion of the vertical heat treatment equipment according to another embodiment of the invention;
Fig. 7 is a schematic diagram for illustrating a distribution of heating temperature of the embodiment of Fig. 5;
Fig. 8 is a block diagram for illustrating an input-power control section; and
Fig. 9 is a sectional view for illustrating an example of the conventional heat treatment equipment.

### BEST MODES FOR CARRYING OUT THE INVENTION

Now, preferred embodiments of the invention will be described in detail with reference to the accompanying drawings.

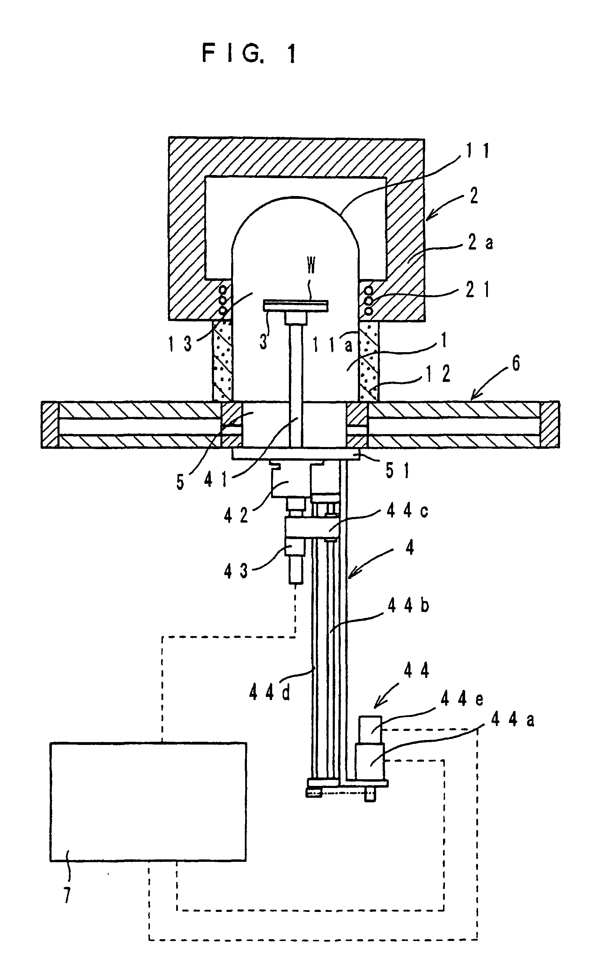

Fig. 1 is a sectional view for illustrating a vertical heat treatment equipment.

The vertical heat treatment equipment essentially comprises a process chamber 1 for introducing a wafer W of the semiconductor as a workpiece, a heating furnace 2 for heating the wafer W introduced in the process chamber 1, a wafer support 3 for carrying thereon the wafer W, an elevator 4 for moving up and down the wafer W carried on the wafer support 3, a carrier chamber 5 disposed under the process chamber 1 and adapted to feed the wafer W to the wafer support 3 or to take out the wafer W therefrom, a handling device 6 facing the carrier chamber 5, and a control section 7 for controlling the drive of the elevator 4 and the handling device 6.

The process chamber 1 comprises a cylinder body 11 having a closed top end and an open bottom end. An upper portion of the cylinder body 11 is enclosed with the heating furnace 2. A side wall 11a of the cylinder body 11 is covered with a heat insulator 12 over a predetermined area of the lower portion thereof. The cylinder body 11 is formed of quartz, SiC or the like and has an arched top portion. An opening at the bottom of the cylinder body 11 communicates with the carrier chamber 5, a bottom of which is closed with a bottom plate 51.

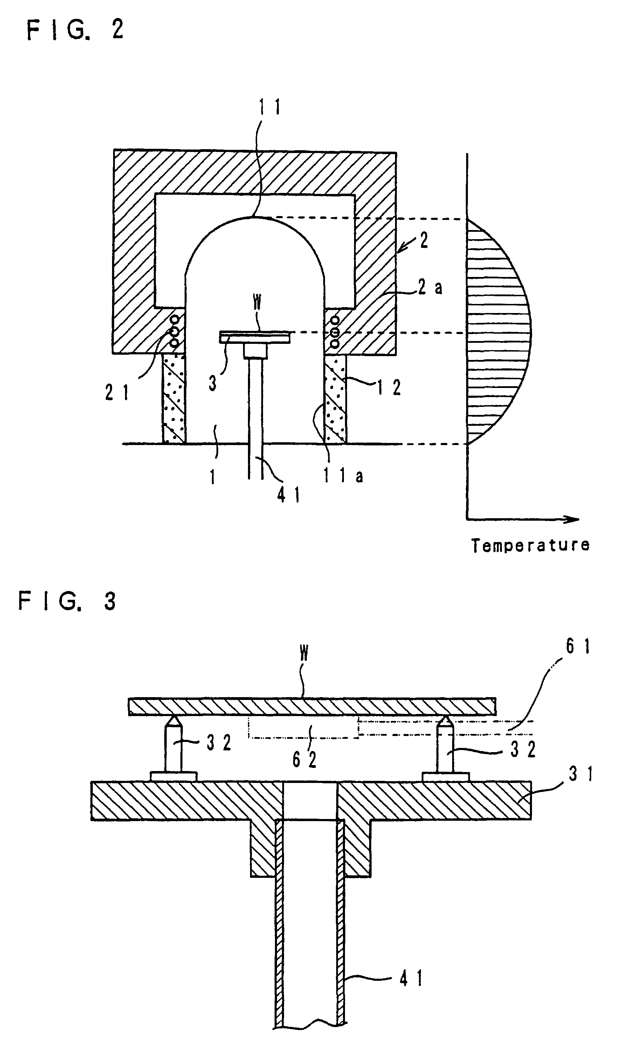

The heating furnace 2 includes a heater 21 of a resistance heating system extended along an inner side of a heating furnace wall 2a. The heater 21 is shaped like a coil and disposed laterally of a heat-treatment position 13 for the wafer W of the semiconductor in a manner to surround the heat-treatment position 13 defined at an upper place in the process chamber 1. The heater 21 corresponds only to the heat-treatment position 13 such that the process chamber 1 may have a distribution in which a heating temperature is at the maximum at the heat-treatment position 13 and gradually decreases as a vertical distance therefrom increases, as shown in Fig. 2.

The wafer support 3 comprises a plate-like base 31 such as formed of quartz, SiC or the like and a plurality of support pins 32, such as formed of quartz, upstanding from the base (see Fig. 3). The respective support pins 32 have a uniform height so as to support the wafer W of the semiconductor in a horizontal position. Lower ends of the support pins 32 are secured to the base 31.

The elevator 4 comprises an elevation rod 41 for supporting the wafer support 3, a hydrostatic bearing 42 for vertically movably supporting an intermediate portion of the elevation rod 41, a support member 43 for supporting a lower portion of the elevation rod 41, and a drive section 44 for causing a vertical movement of the support member 43.

The elevation rod 41 is formed of a quartz tube and has a top end thereof connected with a bottom of the base 31 of the wafer support 3. The interior of the elevation rod defines a gas supply passage for supplying a treatment gas to the wafer W of the semiconductor.

The drive section 44 for causing the vertical movement of the elevation rod 41 comprises a motor 44a, a spiral gear 44b driven by the motor 44a, an elevation member 44c having the support member 43 attached thereto and screwed into the spiral gear 44b, a guide rod 44d for guiding the vertical up-and-down movement of the elevation member 44c, and an encoder 44e for controlling a stroke of the elevation rod 41.

As shown in Fig. 3, the handling device 6 comprises a robotic arm 61 adapted to pivot about a vertical shaft, and a suction member 62 disposed at the distal end of the robotic arm 61 and adapted for vacuum suction of the wafer W of the semiconductor. The handling device 6 operates to feed a wafer W of the semiconductor onto the support pins 32 from a lateral side of the wafer support 3 or to remove the heat-treated wafer W of the semiconductor from the support pins 32, while the wafer support 3 is down at the carrier chamber 5.

The above vertical heat treatment equipment is arranged such that the heater 21 of the heating furnace 2 is located laterally of the heat-treatment position 13 for the wafer W of the semiconductor and therefore, the wafer W and the wafer support 3 are prevented from blocking radiant heat from the heater 21, thus producing no low-temperature region extended under the heat-treatment position 13. This provides a fixed thermal history of the wafer W while the wafer W moves up and down. Thus is assured a processing precision such as of a uniform film thickness of a single wafer W as well as a processing precision such as of a uniform film thickness of a plurality of wafers W, particularly right after the heat treatment has been started. Furthermore, since the process chamber 1 has a distribution in which a heating temperature is at the maximum at the heat-treatment position 13, the wafers W may be subject to an efficient heat treatment.

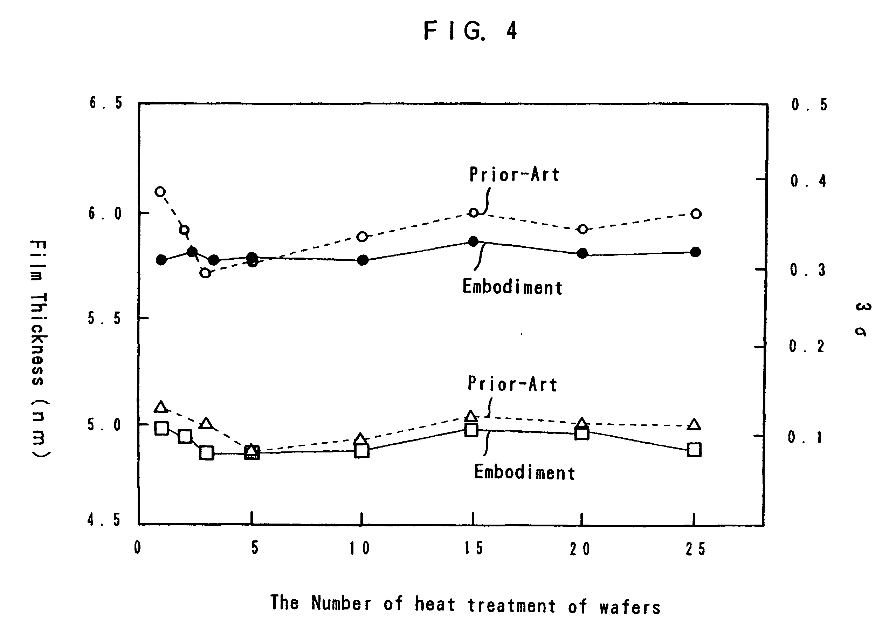

Fig. 4 is a graphical representation of the results of comparison tests of thicknesses of oxide films formed on the wafers of the semiconductor treated by means of the vertical heat treatment equipment according to the above embodiment and the prior-art heat treatment equipment. The heat treatment was carried out under the conditions of a dry treatment gas of O₂, a treatment temperature of 1000°C, and a treatment time of 65 seconds. The wafers of the semiconductor having a size of 8 inches were used in the comparison tests. As the film thickness data, there was found a mean value of measurements at 39 points on a circumference 5-mm inward of the outer circumference of each wafer of the semiconductor. In the figure, the upper lines each denote measurements of the film thicknesses of 25 wafers of the semiconductor sequentially taken one by one over time, whereas the lower lines each denote variations of the film thickness of a single wafer of the semiconductor in terms of 3 σ (σ: dispersion).

As apparent from Fig. 4, the wafers of the semiconductor treated by the vertical heat treatment equipment described above do not suffer the decrease of film thickness which is observed particularly right after the start of the heat treatment. It is also apparent that the variations of the film thickness of a single wafer of the semiconductor treated by the equipment described above are reduced as compared with those of the wafer of the semiconductor treated by the prior-art equipment. Certainly, the equipment described above accomplishes a good uniformity and repeatability of the wafers of the semiconductor.

It is to be noted that the wafer support 3 may adopt a construction comprising two stages vertically arranged and spaced from each other by a predetermined distance, each stage carrying thereon one wafer W of the semiconductor. In this case, as well, the radiant heat from the heater 21 is unblocked and applied to the wafers of the semiconductor from lateral sides thereof and hence, a positive heat treatment thereof can be accomplished.

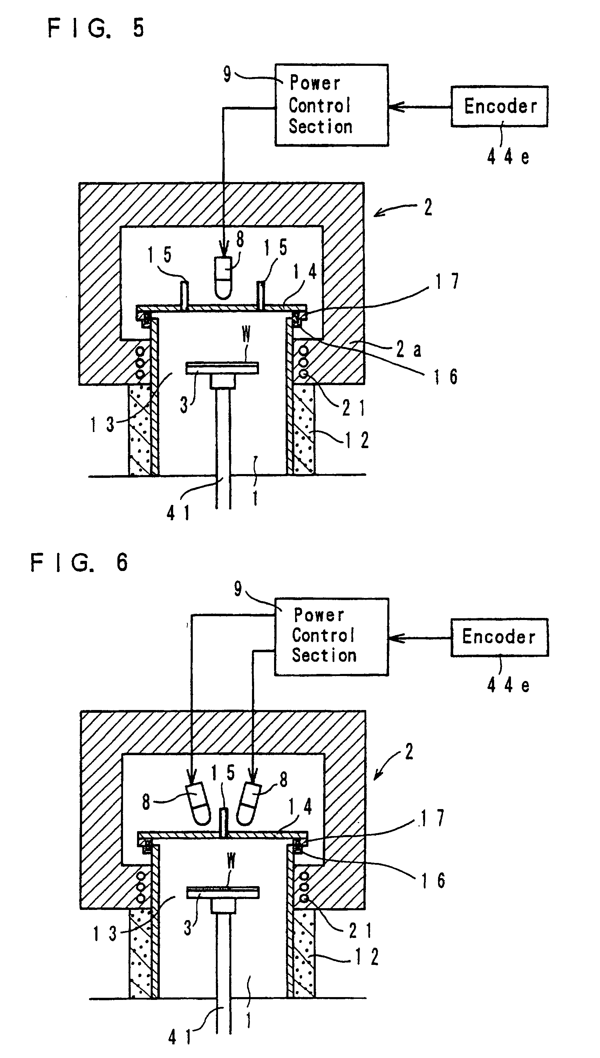

Fig. 5 is a sectional view for illustrating an essential portion of a vertical heat treatment equipment according to an embodiment of the invention. This vertical heat treatment equipment differs from that of Fig. 1 in that a quartz glass plate 14 is disposed at an upper side portion of the cylindrical process chamber 1 by way of a metal-formed water-cooling ring 17 containing therein a cooling channel 16 while a lamp heater 8 excellent in directivity, such as an infrared lamp, halogen lamp and the like, is disposed above the central portion of the quartz glass plate 14. that a power control section 9 is provided for controlling power supplied to the lamp heater 8, and that a plurality of gas supply openings 15 are provided around the lamp heater 8 thereby allowing a treatment gas to flow down directly onto a surface to be treated of the wafer W of the semiconductor.

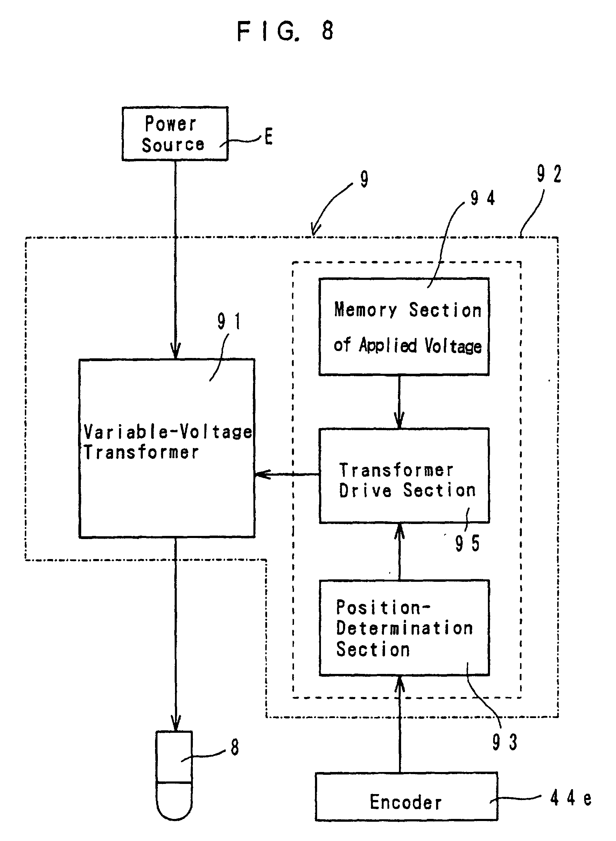

As shown in Fig. 8, the power control section 9 comprises a variable-voltage transformer 91 adapted to transform power supplied from a power source E and to output the power to the lamp heater 8, and a microcomputer 92 for regulating the output power from the variable-voltage transformer 91 based on a signal supplied from the encoder 44e.

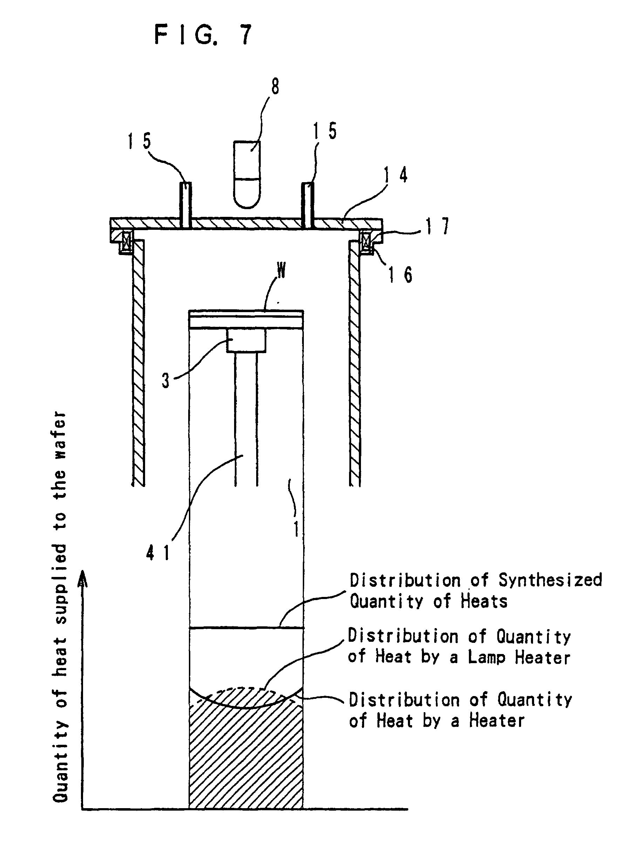

The microcomputer 92 includes a position-determination section 93 responsive to the signal from the encoder 44e to determine a vertical position of the wafer support 3, a memory section of applied voltage 94 containing a voltage to be applied to the lamp heater 8 for each vertical position of the wafer support 3, and a transformer drive section 95 adapted to compare a signal from the position determination section 93 with that from the memory section of applied voltage 94 for providing a real-time variation of the output voltage from the variable voltage transformer 91 in accordance with the vertical position of the wafer support 3. The memory section of applied voltage 94 stores an optimum voltage to be applied to the lamp heater 8 for each vertical position of the wafer support 3 so as to constantly maintain a uniform quantity of heat applied to the central and peripheral portions of the wafer W of the semiconductor regardless of any vertical position of the wafer W (see a graphical representation of distribution of synthesized quantity of heats in Fig. 7).

The vertical heat treatment equipment of this embodiment is adapted to quickly vary the quantity of radiant heat applied to the central portion of the wafer W by way of control of the power to be supplied to the lamp heater 8 by the power control section 9, thus offering a uniform heating of the central and peripheral portions of the wafer W at any different vertical positions. The equipment also allows the treatment gas to flow down directly onto the wafer W via the gas supply openings 15 at the upper portion of the process chamber 1. This is effective to prevent the formation of defective crystal and film of ununiform thicknesses as well as to reduce cycle time of the heat treatment of the wafer W. More specifically, without the lamp heater 8, the peripheral portion of the wafer W receives a larger quantity of heat than the central portion thereof, as illustrated by the graphical representation in Fig. 7. Accordingly, if the wafer W is quickly elevated from the carrier chamber 5 to the heat-treatment position 13, the peripheral portion of the wafer W is heated faster than the central portion thereof, resulting in a temperature difference between the central portion and the peripheral portion thereof and leading to a greater incidence of defective crystals or a film of ununiform thicknesses. On the other hand, if the heat-treated wafer W is quickly lowered from the heat-treatment position 13 to the carrier chamber 5, the central portion of the wafer W is cooled faster than the peripheral portion thereof, resulting in a temperature difference between the central portion and the peripheral portion thereof and leading to a greater incidence of defective crystal or a film of ununiform thicknesses. In contrast, the equipment of the above embodiment utilizes the power control section 9 for real-time regulation of the power supplied to the lamp heater 8 in accordance with the vertical position of the wafer W hereby providing a uniform heating of the central and peripheral portions of the wafer W at any different vertical positions. Therefore, the formation of defective crystal or a film of ununiform thicknesses is less likely even if the wafer W is quickly elevated or lowered to the heat-treatment position. In addition, since the treatment gas is allowed to flow down directly onto a surface to be treated (upper surface) of the wafer W through the gas supply openings, there is no fear of a significant turbulence of the treatment gas flow produced in the vicinity of the wafer W and hence, the formation of the defective crystal or the film of ununiform thicknesses is further positively prevented. Accordingly, the equipment of this embodiment provides for the prevention of the formation of the defective crystal and the film of ununiform thicknesses, the assurance of the uniformity and repeatability of the wafers of the semiconductor and the reduction of the cycle time of the heat treatment of the wafers W.

It is to be noted here that although the above embodiment has an arrangement such that the lamp heater 8 is disposed at the central portion of the process chamber 1 and surrounded by a plurality of gas supply openings 15, an arrangement may be made, as shown in Fig. 6, such that only one gas supply opening 15 is disposed at the center upper portion of the process chamber 1 and surrounded by a plurality of lamp heaters 8.

It should be appreciated that the vertical heat treatment equipment of the invention is not limited to the aforementioned embodiments. For example, the embodiment of the invention shown in Figs. 5 and 6 may be carried out without the power control section 9. In this case, as well, the lamp heater 8 may be used for heating the central portion of the wafer W set at the heat-treatment position 13 so as to prevent the production of temperature difference between the central portion and the peripheral portion thereof. Thus is provided a uniform and efficient heat treatment of the workpiece. Additionally, the embodiment of Fig. 1 may also include the lamp heater 8 and the gas supply opening 15 in the upper portion of the process chamber 1.

As a matter of course, the vertical heat treatment equipment of the invention is applicable to heat treatments of other workpieces, such as liquid crystals and the like, besides the aforementioned wafers of the semiconductor.

## Claims

1. A vertical heat treatment apparatus comprising:
a support (3) for carrying thereon a workpiece (W),
elevating means (4) for transportation of the workpiece (W) on said support (3) between a carrier chamber (5) and a heat-treatment position in a process chamber (1), and
a heating furnace (2) including a heater (21) of a resistance heating system for heating the workpiece (W) transported to said heat-treatment position, wherein said heater (21) is disposed laterally of said heat-treatment position in said process chamber (1) whereby said process chamber (1) has a distribution in which a heating temperature is the highest at said heat-treatment position and gradually decreases as a vertical distance therefrom increases, **characterised in that** the apparatus further comprises a lamp heater (8) being disposed at an upper place in said process chamber (1) for heating a central portion of the workpiece (W).

2. A vertical heat treatment equipment as set forth in claim 1, further comprising a power control section (9) for controlling power supplied to said lamp heater (8) in accordance with a vertical position of the workpiece (W) thereby maintaining a uniform quantity of heat applied to the central and peripheral portions of the workpiece (W) at any different vertical positions.

3. A vertical heat treatment equipment as set forth in claim 1 or claim 2, further comprising a gas supply opening (15) disposed at an upper place in said process chamber (1) for supplying a treatment gas to the workpiece (W).

## Patentansprüche

1. Eine vertikale Wärmebehandlungsvorrichtung, die folgendes aufweist:
einen Träger (3) zum Tragen eines Werkstücks (W) darauf,
Hubmittel (4) zum Transportieren des Werkstücks W auf dem Träger (3) zwischen einer Trägerkammer (5) und einer Wärmebehandlungsposition in einer Prozesskammer (1), und
einen Heizofen (2) einschließlich einer Heizvorrichtung (21) eines Widerstandsheizsystems zum Erhitzen des Werkstücks (W), das zu der Wärmebehandlungsposition transportiert wird, wobei die Heizvorrichtung (21) seitlich bezüglich der Wärmebehandlungsposition in der Prozesskammer (1) angeordnet ist, wobei die Prozesskammer (1) eine Wärmeverteilung besitzt, bei der die Heiztemperatur an der Wärrnebehandlungsposition am höchsten ist und sich graduell verringert, wenn sich der Vertikalabstand von der Wärmebehandlungsposition erhöht, **dadurch gekennzeichnet, dass** die Vorrichtung ferner eine Lampen-Heizvorrichtung (8) aufweist, die an einem oberen Platz in der Prozesskammer (1) angeordnet ist zum Erhitzen eines Mittelteils des Werkstücks (W).

2. Vertikaler Wärmebehandlungsvorrichtung nach Anspruch 1, die ferner folgendes aufweist: einen Leistungssteuerabschnitt (9) zum Steuern der an die Lampenheizvorrichtung (8) gelieferten Leistung, und zwar gemäß einer Vertikalposition des Werkstücks (W), um dadurch eine gleichförmige Menge an Wärme beizubehalten, die an den mittleren und die Umfangsteile des Werkstücks (W) an irgendwelchen unterschiedlichen Vertikalpositionen angelegt wird.

3. Vertikale Wärmebehandlungsvorrichtung nach Anspruch 1 oder 2, wobei die Vorrichtung ferner eine Gasversorgungsöffnung (15) aufweist, die an einem oberen Ort in der Prozesskammer (1) angeordnet ist, zum Liefern eines Behandlungsgases an das Werkstück (W).

## Revendications

1. Dispositif de traitement thermique vertical comprenant :
- un support (3) sur lequel est portée une pièce de fabrication (W) ;
- un moyen d'élévation (4) pour transporter la pièce de fabrication (W) sur ledit support (3) entre une chambre de chargement (5) et une position de traitement thermique dans une chambre de traitement (1) ; et
- un four de chauffage (2) incluant un élément de chauffage (21) d'un système de chauffage par résistance pour chauffer la pièce de fabrication (W) transportée vers ladite position de traitement thermique, dans lequel ledit élément de chauffage (21) est disposé latéralement par rapport à ladite position de traitement thermique dans ladite chambre de traitement (1), ainsi ladite chambre de traitement (1) présente une distribution dans laquelle une température de chauffage est la plus élevée au niveau de ladite position de traitement thermique et diminue progressivement au fur et à mesure qu'une distance verticale à partir de celle-ci augmente, **caractérisé en ce que** l'appareil comprend de plus un élément de chauffage à lampe (8) disposée à un endroit supérieur dans ladite chambre de traitement (1) pour chauffer une partie centrale de la pièce de fabrication (W).

2. Equipement de traitement thermique vertical selon la revendication 1, comprenant de plus une section de régulation de puissance (9) pour réguler la puissance fournie à ledit élément de chauffage à brûleur (8) conformément à une position verticale de la pièce de fabrication (W), maintenant ainsi une quantité uniforme de chaleur appliquée aux parties centrales et périphériques de la pièce de fabrication (W) à toutes positions verticales différentes.

3. Equipement de traitement thermique vertical selon la revendication 1 ou 2, comprenant de plus une ouverture d'alimentation en gaz (15) disposée à un endroit supérieur dans ladite chambre de traitement (1) pour alimenter un gaz de traitement à la pièce de fabrication (W).
